(19) Europäisches Patentamt
European Patent Office
Office européen des brevets

(11) **EP 0 534 068 B1**

(12) **EUROPÄISCHE PATENTSCHRIFT**

(45) Veröffentlichungstag und Bekanntmachung des Hinweises auf die Patenterteilung:
**20.03.1996 Patentblatt 1996/12**

(51) Int Cl.⁶: **H02M 7/5387**

(21) Anmeldenummer: **92111046.6**

(22) Anmeldetag: **30.06.1992**

(54) **Anlage der Plasma- und Oberflächentechnik**

Equipment used in plasma- and surface-treatment-technique

Equipement utilisé dans la technique des plasmas et du traitement des surfaces

(84) Benannte Vertragsstaaten:
**AT CH DE ES FR GB IT LI NL SE**

(30) Priorität: **31.07.1991 DE 9109503 U**

(43) Veröffentlichungstag der Anmeldung:
**31.03.1993 Patentblatt 1993/13**

(73) Patentinhaber: **MAGTRON MAGNETO ELEKTRONISCHE GERÄTE GmbH**
**D-77833 Ottersweier (DE)**

(72) Erfinder: **Mark, Günter**
**W-7583 Ottersweier (DE)**

(74) Vertreter: **Zipse & Habersack**
**Lessingstrasse 12**
**D-76530 Baden-Baden (DE)**

(56) Entgegenhaltungen:
DE-A- 3 712 185      DE-A- 3 733 263
GB-A- 2 143 998      US-A- 4 520 437
US-A- 4 719 558

• WELDING JOURNAL, Februar 1988, Nr. 2, Miami, FL, US, Seiten 48-50; M.B. FRAPPIER : "Plasma Arc Cutting Power Supplies Explained"

**Beschreibung**

Die Erfindung betrifft ein Verfahren zur Steuerung der Versorgung einer Anlage der Plasma- und Oberflächentechnik mit einem geregelten Gleichspannungsnetzteil.

Bei der Plasmatechnik können auf dem Wege elektrischer Gasentladungen in einem Behälter technische Verfahren angewendet werden, die trocken und berührungslos eine Oberfläche verändern, aktivieren oder beschichten können. Die gewünschten Effekte werden dabei auf physikalischem (PVD) oder können beispielsweise auch auf chemischem Wege (Plasma-CVD) ausgelöst werden.

Zum Betrieb der elektrischen Entladung zur Erzeugung des Plasmas sind Hochfrequenzgeneratoren bekanntgeworden, die den Erfordernissen der Plasmaentladung angepaßt sind. Diese durch Hochfrequenz, beispielsweise mit einer Frequenz von 13,65 MHz, erzeugten Plasmen sind bei hochenergetischen Anwendungen sehr teuer, und die Sicherheitsanforderungen für den Menschen sind recht hoch.

Ein derartiger Hochfrequenzgenerator ist beispielsweise in der DE-A-37 33 263 beschrieben. Mit diesem Hochfrequenzgenerator wird eine Last, die im wesentlichen Resonanzkreis ist, mit einer einstellbaren Energie versorgt, deren Frequenz gleich oder nahezu gleich der Eigenresonanz der Last zu einem gegebenen Zeitpunkt ist.

In dem Aufsatz "Plasma Arc Cutting, Power Supplies Explained" von M. B. Frappier, in: Welding Journal, Februar 1988, Nr. 2, Seiten 48-50, Miami, wird ein Verfahren beschrieben, bei dem auf ein Plasmaschweißgerät unidirektionale Pulse gegeben werden, welche Pulse durch eine Phasenverschiebung in der Ansteuerung zweier Leistungsschalter erzielt wird. Ein derartiges Verfahren zur Pulsbreitenmodulation, bei dem Leistungsschalter einer Brückenschaltung separat angesteuert werden, ist ebenfalls aus der US-4 719 588 und der DE-A- 37 12 185 bekannt. Durch die Phasendifferenz in der Ansteuerung zweier Gruppen mit jeweils zwei Leistungsschaltern wird dort die Breite der positiven und negativen Pulse gemeinsam variiert, wodurch eine regelbare Ausgangsleistung erzielt wird.

Demgegenüber liegt der vorliegenden Erfindung die Aufgabe zugrunde, in Abweichung von einem Hochfrequenzgenerator ein Verfahren zur Steuerung der Versorgung einer Anlage der Plasma- und Oberflächentechnik zu schaffen, das im Hinblick auf die Lösung des oben genannten Problems wesentliche Vorteile aufweist, und das es ermöglicht, die Ionen- und Elektronenströme in einem Plasmaprozeß zu steuern.

Zur Lösung der gestellten Aufgabe wird ein Verfahren gemäß Patentanspruch 1 vorgeschlagen.

Mit dem Verfahren gemäß der Erfindung wird der wesentliche Vorteil erreicht, daß die verhältnismäßig teuere HF-Stromversorgung von ca. 13,65 MHz durch eine bipolare Pulsstromversorgung von 0 bis 50 KHz ersetzt wird. Der wesentliche Vorteil des Einsatzes einer bipolaren Pulsstromversorgung liegt vor allem in der besseren Steuerung des Elektronen- und Ionenflusses bei plasmatechnischen Anwendungen. Hierbei kann auf einfache Art und Weise ein steuerbares elektrisches Wechselfeld erzeugt werden.

Eine weitere Ausbildung der Erfindung ergibt sich aus den Patentansprüchen 2 und 3.

Der wesentliche Vorteil des erfindungsgemäßen Verfahrens besteht darin, daß Impulse im positiven Spannungsbereich unabhängig von den Impulsen im negativen Spannungsbereich in ihrer zeitlichen Breite verändert werden können. Desweiteren kann wahlweise nur mit der oberen, positiven Spannungszeitfläche oder mit der unteren, negativen Spannungszeitfläche gearbeitet werden, wobei ein besonderer Vorteil des erfindungsgemäßen Verfahrens darin besteht, daß entsprechend dem gewünschten Programm der Plasma-Anwendungen mit Hilfe elektronischer Steuerungen beliebige Impulsformen eingestellt werden können, die jeweils auf den entsprechenden Plasma-Anwendugsbereich angepaßt werden können.

Anhand der Zeichnungen soll am Beispiel bevorzugter Ausführungsformen das Verfahren gemäß der Erfindung näher erläutert werden.

In den Zeichnungen zeigt

Fig. 1  ein Prinzipblockschaltbild einer Schaltungsanordnung zur bipolaren Pulsstromversorgung.

Fig. 2  zeigt das Prinzip der Brückenkonfiguration der MOSFETs.

Fig. 3  zeigt ein Impulsdiagramm der bipolaren Pulsstromversorgung.

Fig. 4  zeigt eine Brückenkonfiguration gemäß Fig. 2 mit anderer Aktivität der Zweige.

Fig. 5  zeigt ein vollständiges Blockschaltbild der Schaltungsanordnung zur Realisierung der Erfindung.

Fig. 6  zeigt ein Blockschaltbild eines Zweiges mit mehreren MOSFETs.

Fig. 7  zeigt ein geändertes Blockschaltbild der Schaltungsanordnung zur bipolaren Pulsstromversorgung.

Fig. 8    zeigt eine Prinzipdarstellung des Verfahrens gemäß der Erfindung mit einem Prozeßrechner, einer Regeleinrichtung durch mathematische Operationen zur Steuerung des Plasmas in einer Plasma kammer.

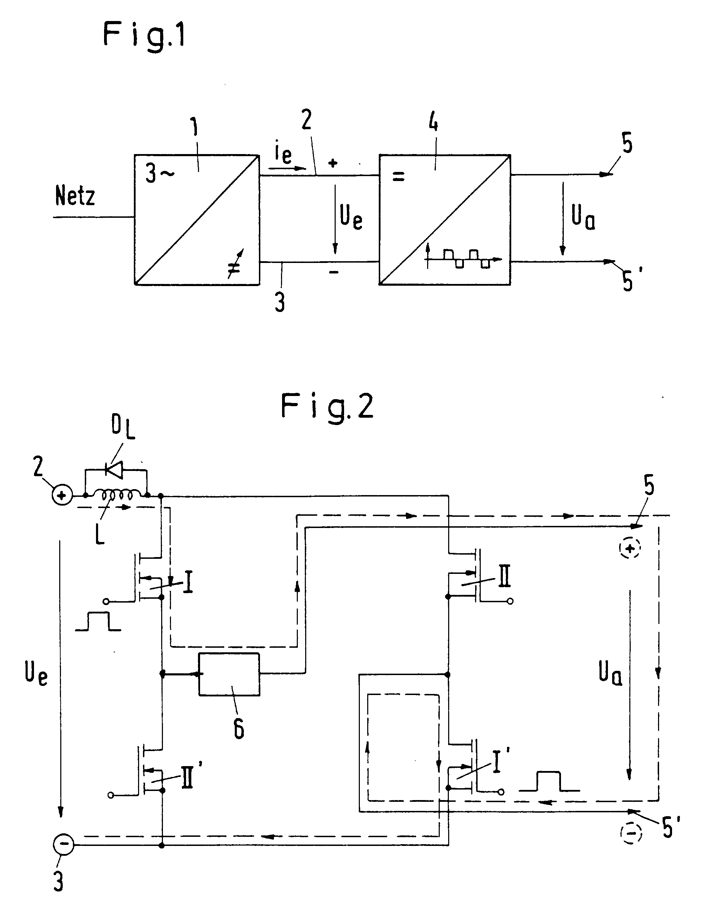

Wie sich aus Fig. 1 ergibt, besteht die Schaltungsanordnung für das Gerät zur bipolaren Stromversorgung nach dem Verfahren gemäß der Erfindung aus einem Gleichstromnetzteil 1, dessen positiver Ausgang 2 und dessen negativer Ausgang 3 mit dem Brückeneingang einer MOSFET-Brückenkonfiguration 4 inklusive Steuerelektronik geschaltet ist. Die Ausgänge 5, 5' der Brückenkonfiguration sind mit der Plasmakammer verbunden.

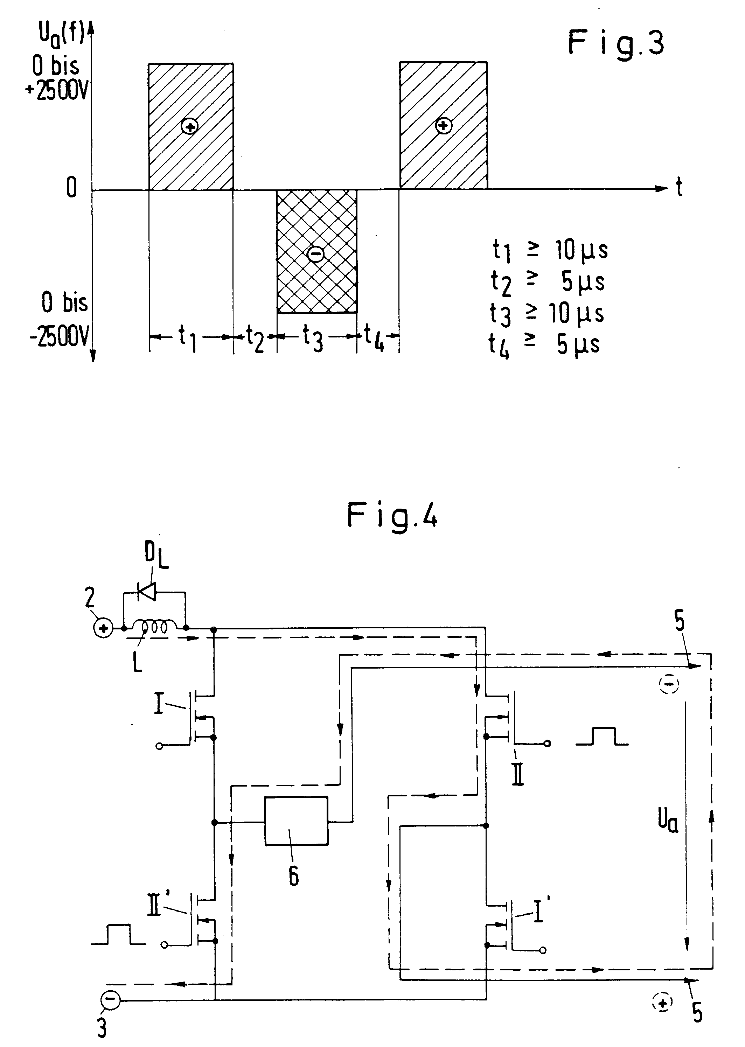

Wie sich aus den Figuren 2 und 4 ergibt, besteht die Brückenschaltung aus je zwei in Brücke geschalteten MOSFETs I, I' und II, II'. An den Brückeneingang sind die beiden Klemmen 2, 3 des Netzteiles 1 geschaltet, so daß die regel- und einstellbare Spannung Ue der Brücke zugeführt wird. Der Brückenausgang der MOSFET-Brückenschaltung ist mit einem Stromerfassungsbauteil 6 verbunden und führt zu einer Ausgangsklemme 5. Der andere Brückenausgang ist mit dem anderen Ausgang 5' verbunden. Durch entsprechende Ansteuerung der Steuerelektroden der MOSFETs I, I', II, II' kann eine beliebige bipolare Puls) spannung an den Ausgängen 5, 5' erzeugt werden. Im Wechsel wird hierbei die Brückenkonfiguration diagonal geschaltet, so daß die Polarität an den Ausgangsklemmen 5, 5' wechselt. Ist, wie in Fig. 2 dargestellt, der Diagonalzweig I, I' aktiv, ist der Diagonalzweig II, II' inaktiv. Zum Umschalten von einem Diagonalzweig auf den jeweils anderen wird eine Ruhezeit von mindestens 5 µs benötigt. Der Stromverlauf ist in Fig. 2 gestrichelt dargestellt. In Fig. 4 ist der Diagonalzweig II, II' aktiv, so daß ein umgekehrter Stromverlauf erfolgt, der ebenfalls gestrichelt dargestellt ist. Die Induktivität L (Figuren 2, 4, 5) schützt den jeweils aktiven MOSFET-Zweig vor einem zu hohen Stromanstieg (DL arbeitet als Freilaufdiode). Das Pulsmuster Ua(t) mit der kleinsten Periodenzeit ist in Fig. 3 dargestellt. Die Zeiten t1 bis t4 sind frei einstellbar. Desweiteren kann wahlweise nur mit der oberen, positiven Spannungszeitfläche oder mit der unteren, negativen Spannungszeitfläche gearbeitet werden., wobei jeweils dann nur ein Diagonalzweig I, I' oder II, II' aktiv ist.

Die Ausgangsimpulse sind bis zu Spannungslagen von 2500 V und einer Pulsleistung von 10 KW möglich, Spannungslagen bis 1200 V dagegen bis zu einer Pulsleistung von 150 KW. Die obere Grenzfrequenz beträgt 50 KHz.

Bei Normalbetrieb, Spannungsüberschlägen (arcs) oder Kurzschlüssen innerhalb des Plasmas erfaßt der Stromerfassungsbaustein 6 den aktuellen Strom, und es begrenzt die Induktivität L den Stromanstieg (endliches $\frac{di}{dt}$ zum Schutz der MOSFETs). Der Stromerfassungsbaustein 6 schaltet bei Überstrom den jeweils aktiven Zweig ab. Der Betrieb wird nach Abklingen des Kurzschlußstroms erst wieder fortgesetzt, wenn er den Wert 0 A nahezu erreicht hat.

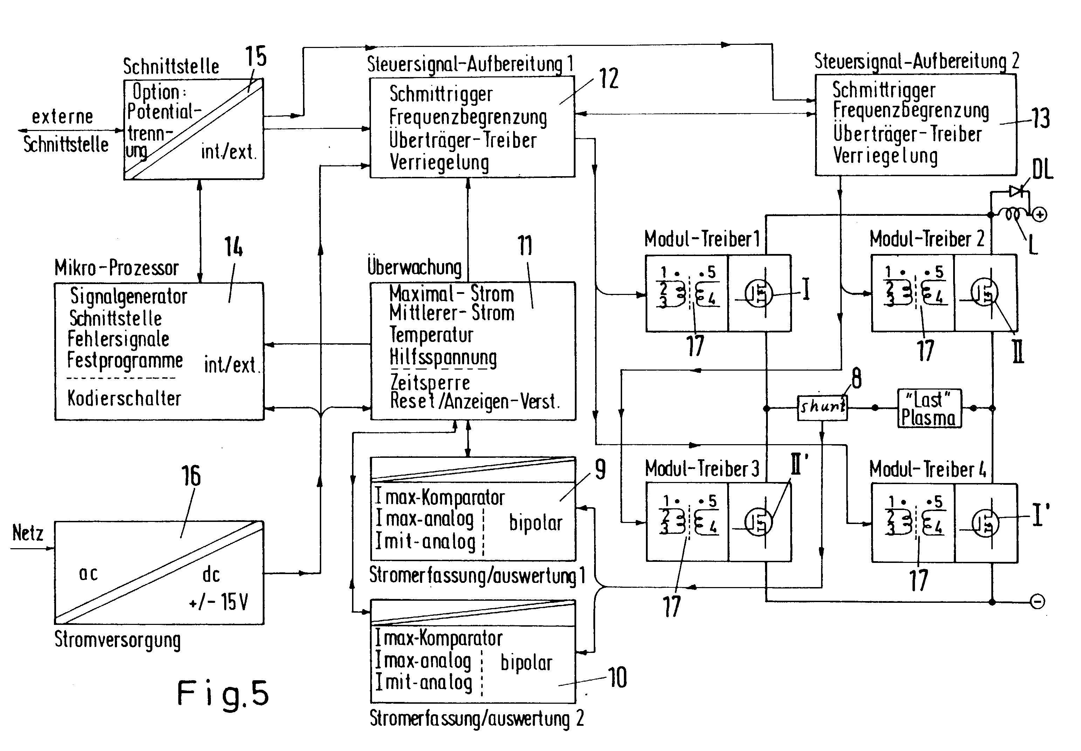

In Fig. 5 ist ein komplettes Blockschaltbild der Schaltungsanordnung dargestellt. Die MOSFETs I, I' und II, II' sind in einer Brücke geschaltet, und der Stromerfassungsbaustein besteht aus einem Shunt 8, dessen Abgriff mit zwei Stromerfassungs- und -auswertebausteinen 9, 10 verbunden ist, die bipolar einen Imax-Komparator und eine Imax-Analog- und Imit-Analog-Auswertung umfassen. Die Ausgänge dieser Bausteine sind mit einem Überwachungsbaustein 11 verbunden, der zum Überwachen des Maximalstroms, des mittleren Stroms, der Temperatur und einer Hilfsspannung dient und mit einer Zeitsperre, einem Reset und einem Anzeigeverstärker versehen ist. Der Überwachungsbaustein 11 ist mit einem ersten Steuersignalaufbereitungsbaustein 12 und einem zweiten Steuersignalaufbereitungsbaustein 13 verbunden, wobei über einen Mikroprozessor 14 und eine Schnittstelle 15 die Steuersignalaufbereitungsbausteine 12, 13 gesteuert werden. Diese enthalten einen Schmittrigger, eine Frequenzbegrenzung, einen Übertragertreiber und eine Verriegelung. Die Stromversorgung für die gesamte Elektronik ist durch das Bauteil 16 dargestellt.

Die Steuersignale werden von den Bauteilen 12, 13 über besondere Modultreiber 17 den einzelnen MOSFETs I, I' und II, II' zugeführt. Entsprechend dem Programm des Mikroprozessors wird dann die gewünschte bipolare Pulsstromerzeugung durchgeführt.

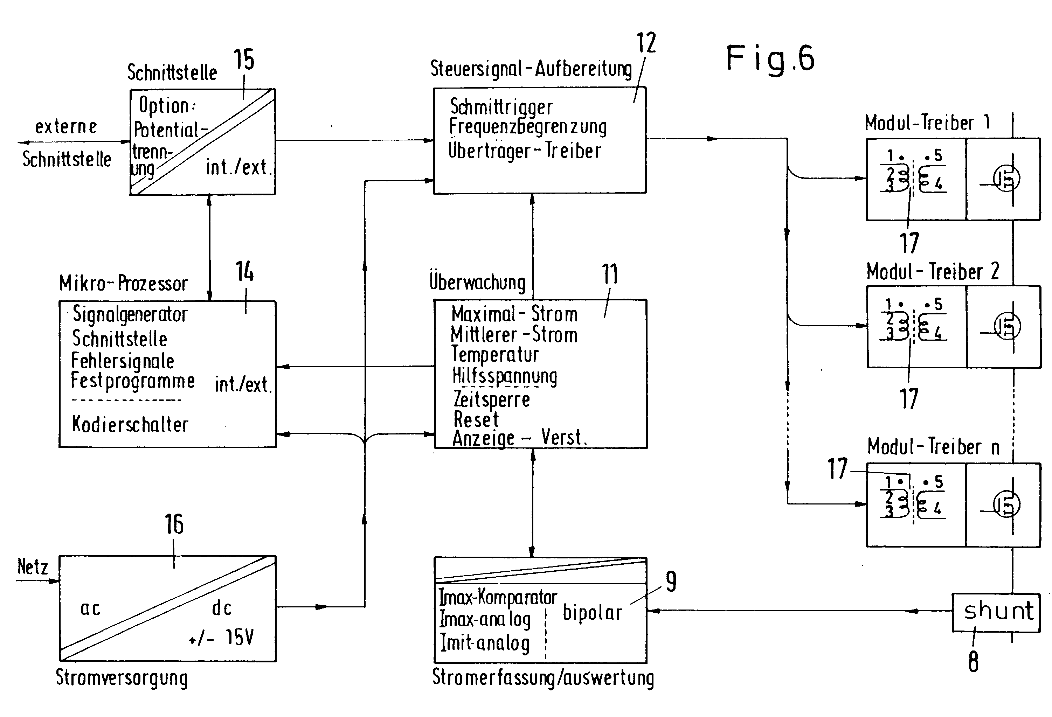

In Fig. 6 ist ein Teil der gleichen Schaltungsanordnung wie in Fig. 5 dargestellt, wobei jedoch in der Brücke bis zu n MOSFETs mit einer entsprechenden Anzahl von Treibern 17 enthalten sein können. Die Reihenschaltung wird verwendet, um Spannungen bis 2500 V zu realisieren.

Die bipolare Pulsstromversorgung mit einem Gerät mit einer Schaltungsanordnung nach dem Verfahren gemäß der Erfindung weist mehrere Vorteile auf. Die durch Hochfrequenz erzeugten Plasmen sind lokal mit einer Abstrahlungscharakteristik gebunden. Bipolare Pulsplasmen können ein vollständiges Raum-Plasma innerhalb einer Kammer bilden (Potential zwischen Gehäuse und Substrat) und somit Materialien auch bei beliebiger Geometrie vollständig umschließen. Ferner können bipolare Pulsplasmen hochenergetisch bis derzeit 150 KW Pulsleistung aufgebaut und somit auch bei großtechnischen Anlagen industriell eingesetzt werden.

Desweiteren bieten Plasmen, die mit Gleichspannung oder unipolaren Pulsen erzeugt werden, nicht die Möglichkeiten, wie eine bipolare Pulsquelle (z. B. die Beschichtung von Halbleitern und Nichtleitern).

HF-Plasmen bei 13,65 MHz und deren Erzeugung sind bei hochenergetischen Anlagen sehr teuer, wobei die Sicherheitsanforderungen für den Menschen sehr hoch sind. Bei den bipolaren Pulsquellen wird im KHz-Bereich von 0 bis 50 KHz gearbeitet, so daß der Sicherheitsaspekt und die Anlagekosten wesentlich niedriger sind.

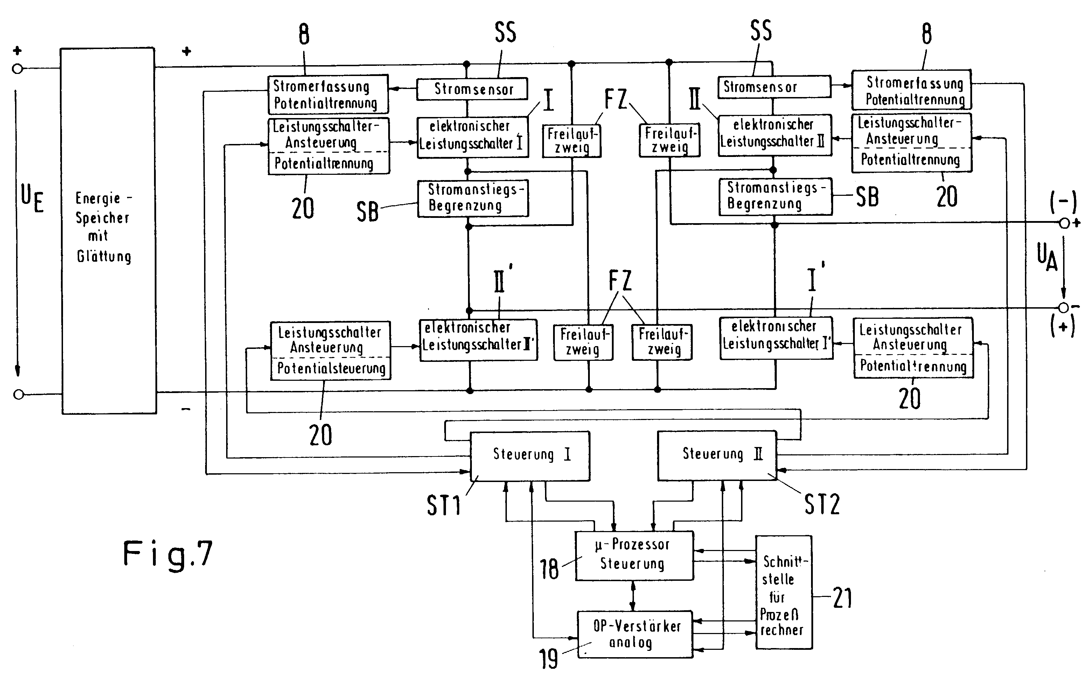

Die Schaltungsanordnung gemäß Fig. 7 zeigt eine weitere Variante der Schaltungsanordnung gemäß Fig. 5. Hierbei können als elektronische Leistungsschalter I, I', II, II'' in der Brücke alle verfügbaren elektronischen Bauelemente eingesetzt werden, d. h. MOSFETs, bipolare Transistoren, IGBTs (isolated gate bipolar transistor) usw., was auch für die Schaltungsanordnung gemäß Fig. 5 gilt. Zur Realisierung steiler Impulsflanken ist ein kapazitiver Energiespeicher ES der gleichgerichteten Spannung UE nachgeschaltet, der zur Impulsverbesserung beiträgt.

Die Stromanstiegsgeschwindigkeit wird nicht mehr durch die Induktivität L (wie in Fig. 5) im Ausgangskreis begrenzt, sondern im jeweiligen Leistungszweig befindet sich je eine aus einer Induktivität bestehende Stromanstiegsbegrenzung SB, die aus einer Induktivität besteht, und Freilaufzweigen FZ, die jeweils durch eine Diode repräsentiert werden. Die Stromerfassung erfolgt durch Stromsensoren SS in den jeweiligen Zweigen und ist separat in ihren Ansprechschwellwerten unabhängig voneinander einstellbar. Es sind zwei besondere Steuerkreise ST1, ST2 vorgesehen, die die Stromerfassung 8 aufnehmen und von einer Mikroprozessorsteuerung 18 und einer analogen OP-Verstärkeranordnung 19 betätigt werden, wodurch die Leistungstreiberansteuerung 20 für die elektronischen Leistungsschalter I, I', II, II' gesteuert werden. Die Mikroprozessorsteuerung 18 und die analoge OP-Verstärkeranordnung 19 sind über eine Schnittstelle mit einem Prozeßrechner 21 verbunden.

Mit der variierten Schaltungsanordnung ist eine Steuerung und Regelung der Plasmaintensität in Abhängigkeit der eingebrachten Leistung, des Ortes und der Zeit einer bipolaren Pulsstromversorgung möglich.

Bedingt durch die freie Einstellbarkeit und Wahlmöglichkeit für die bipolare Pulseinheit gemäß der Schaltungsanordnung nach der Erfindung in DC +, DC -, unipolar +, unipolar - und bipolar sind Steuer- und Regelfunktionen möglich, die eine Plasmabearbeitung von Materialien, wie Leiter, Halbleiter und Nichtleiter, ermöglichen.

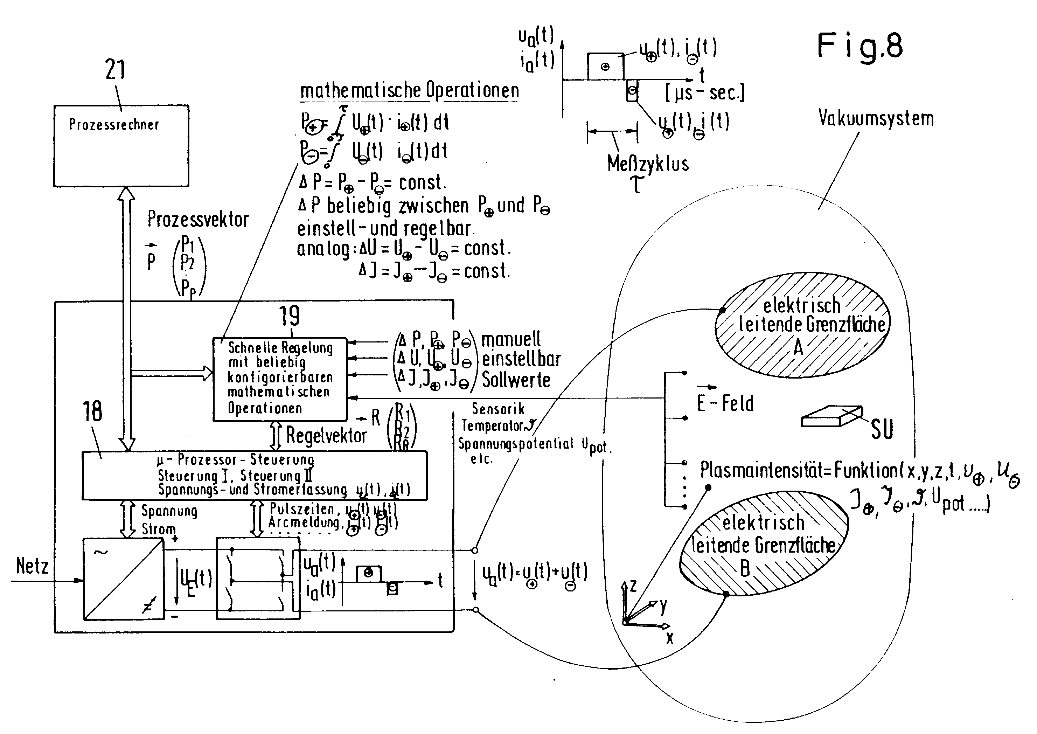

Die Steuerung der Plasmaintensität als Funktion des Ortes XYZ und der Zeit t sowie der eingebrachten Leistung P über das Plasma zwischen den elektrisch leitenden Flächen A, B ist in Fig. 8 dargestellt. Das Substrat kann von den Grenzflächen A oder B gebildet werden. Bei halb- und nichtleitenden Substraten kann es sich außerhalb der Grenzflächen A, B, wie durch SU in Fig. 8 dargestellt, an einem frei wählbaren Ort innerhalb des Plasmasystems befinden. A oder B kann auch die Kammerwand des Vakuumsystems oder Teile davon selbst darstellen, in dem das Vakuum erzeugt wird.

Über den Prozeßrechner 18 werden mit dem Prozeßvektor P (P1 ... Pp) der Regel- und Steuereinheit ST1, ST2 Befehle und Meldungen übermittelt. Der Regelvektor R (R1... Rr) bewirkt mit der bipolaren Pulseinheit als Stellglied die Steuerung und Regelung des Plasmas. Dadurch ist eine schnelle Regelung mit beliebig konfigurierbaren, mathematischen Operationen möglich. Für hochempfindliche, hochgenaue und vor allem zur Instabilität neigende Plasmaprozesse (arcing) kann es notwendig sein, eine schnelle Regelung mit beliebig konfigurierbaren mathematischen Operationen optional zu verwenden, wie in Fig. 8 dargestellt. Als Ist-Werte dienen die elektrischen Größen $u_a(t) = u_\oplus(t) + u_\ominus(t)$ und $i_a(t) = i_\oplus(t) + i_\ominus(t)$, $\oplus$ = positiver Puls, $\ominus$ = negativer Puls.

Aus diesen elektrischen Größen können innerhalb eines Meßzyklus $\tilde{\tau}$ ( $\tilde{\tau}$ kann sich auf beliebig viele Meßperioden erstrecken) über bekannte, analoge Operationsverstärkerschaltungen (Addierer, Subtrahierer, Integrierer, Differenzierer, PI - PID-Regler usw.) 9 folgende Größen ermittelt werden:

**1) Spannung**

$$U_\oplus = \int_{\cdot}^{\tilde{\tau}} U_\oplus(t)\, dt$$

$$U_\ominus = \int_{\cdot}^{\tilde{\tau}} U_\ominus(t)\, dt$$

$$\blacktriangle U = U_\oplus - U_\ominus = \text{const.}$$

$\blacktriangle U$ beliebig einstellbar / regelbar zwischen $U_\oplus$ und $U_\ominus$

**2) Strom**

$$I_\oplus = \int_{\cdot}^{\tilde{\tau}} i_\oplus(t)\, dt$$

$$I_\ominus = \int_{\cdot}^{\tilde{\tau}} i_\ominus(t)\, dt$$

$$\blacktriangle I = i_\oplus - i_\ominus = \text{const.}$$

$\blacktriangle I$ beliebig einstellbar / regelbar zwischen $I_\oplus$ und $I_\ominus$

**3) Leistung**

$$P_\oplus = \int_{\cdot}^{\tilde{\tau}} U_\oplus(t) \cdot i_\oplus(t)\, dt$$

$$P_\ominus = \int_{\cdot}^{\tilde{\tau}} U_\ominus(t) \cdot i_\ominus(t)\, dt$$

$$\blacktriangle P = P_\oplus - P_\ominus = \text{const.}$$

$\blacktriangle P$ beliebig einstellbar / regelbar zwischen $P_\oplus$ und $P_\ominus$

Die entsprechenden Sollwert-Einstellungen zur Bildung von 1) bis 3) sind vollautomatisch über den Prozeßvektor P oder über eine manuelle Einstellung möglich. Je nach plasmatechnischer Anwendung, wie z. B.

Ätzen (Reinigen),

Härten,
Beschichten,
Implantieren,
Erwärmung (ohne Härtung),
Sputtern usw.

kann eine Auswahl 1 aus 3 getroffen werden. Diese Art, das Plasma über die elektrischen Größen $u_a$ (t), $i_a$ (t), $P_a$ (t) direkt zu regeln, ist in dieser Anordnung durch die direkte Beeinflussung der Pulszeitflächen ⊕ und ⊖ im μs- bis sec-Bereich sehr exakt möglich. Eine z. B. prozeßrechnergesteuerte Plasmaintensität = Funktion (x, y, z, t, u⊕, u⊖, i⊕, i⊖, $\vartheta$, $U_{Pot}$ ...) kann zur Substratbearbeitung bzw. Behandlung sehr komplexer Prozesse hinzugezogen werden. Eine geeignete Sensorik, z. B. eine Temperaturverteilung ($\vartheta$) oder eine Spannungspotentialverteilung ($U_{Pot}$), kann als überlagerte Regelung mit hinzugezogen werden. Dies ist durch das Bezugszeichen 22 in Fig. 8 angedeutet.

Eine hochleistungsfähige elektrische Pulsmessung $u_a$ (t), $i_a$ (t), $P_a$ (t) mit entsprechender Regelung kann dazu dienen, Elektronen- und Ionenströme optimal für einen Plasmaprozeß zu regeln. Hohlkathodeneffekte können z. B. mit der bipolaren Technik durch die separate Steuerung/Regelung der positiven und negativen Pulsanteile eliminiert werden. Die arc-Empfindlichkeit kann bei schnellen Übergängen von der Glimmentladung zur Bogenentladung reduziert bzw. vermieden werden.

Das Verfahren gemäß der Erfindung ist für plasmagestützte Verfahren einsetzbar, wie zum Beispiel:

- PVD-Technik (PVD = physical vapor deposition),
- CVD-Technik (CVD = chemical vapor deposition),
- Plasma-CVD,
- Plasmanitrieren,
- Kathodenzerstäubung,
- Oberflächenreinigung (Ätzen mittels Plasma),
- Plasmatechnische Behandlung (Beschichtung, Reinigung),
- Ionenimplantation.

## Patentansprüche

1. Verfahren zur Steuerung der Versorgung einer Anlage der Plasma- oder Oberflächentechnik, bei dem ein Stromversorgungsgerät zur bipolaren Stomversorgung der Anlage ein regelbares Gleichstromnetzteil aufweist, dessen positive und negative Ausgangsklemmen mit dem Eingang einer Brückenschaltung (I,I',II,II') von elektronischen Leistungsschaltern verbunden werden, welche Leistungsschalter mit einer Steuersignalaufbereitungseinrichtung (12,13) und ausgangsseitig mit einer Stromerfassungsschaltung (9,10) zur Steuerung der Leistungsschalter und mit der Last der Anlage verbunden sind, wobei für die Leistungsschalter (I,I') zur Erzeugung der positiven Ausgangsspannung $U_⊕$ und die Leistungsschalter (II,II') zur Erzeugung der negativen Ausgangsspannung $U_⊖$ des Ausgangssignals $U_a$ der Brückenschaltung separate Steuersignalaufbereitungseinrichtungen (12,13) und Stromerfassungsschaltungen (9,10) zur individuellen Regelung der positiven und negativen Ausgangssignale $U_a$ vorgesehen sind, die in separaten Regelkreisen zusammengefaßt sind, welche von einer Steuerung (18) unabhängig voneinander gesteuert werden.

2. Verfahren nach Anspruch 1,
dadurch **gekennzeichnet**,
daß die elektronischen Leistungsschalter durch MOSFETs gebildet werden.

3. Verfahren nach Anspruch 1 oder 2,
dadurch **gekennzeichnet**,
daß der Ausgang der Brückenschaltung (I,I',II,II') mit einem Shunt (8) verbunden ist, dessen Abgriff mit den Stromerfassungsschaltungen verbunden wird.

4. Verfahren nach Anspruch 3,
dadurch **gekennzeichnet**,
daß die Stromerfassungs- und Auswerteeinheiten (9,10) mit einer Überwachungseinheit (11) verbunden sind, die den Maximalstrom, den mittleren Strom, die Temperatur und eine Hilfsspannung überwacht, welche Überwachungseinheit ferner mit einer Zeitsperre, einem Reset und einem Anzeigeverstärker versehen ist.

**5.** Verfahren nach Anspruch 4,
dadurch **gekennzeichnet**,
daß die Überwachungseinheit (11) mit einem Mikroprozessor (14) verbunden ist, welcher über eine Schnittstelle (15) die Steuersignalaufbereitungseinrichtungen (12,13) steuert.

**6.** Verfahren nach einem der vorhergehenden Ansprüche,
dadurch **gekennzeichnet**,
daß die Steuersignalaufbereitungseinrichtungen (12,13) mit einem Schmitttrigger, einer Frequenzbegrenzung, einem Überträgertreiber und einer Verriegelung zur Steuerung der Leistungsschalter (I, I',II,II') versehen sind.

**7.** Verfahren nach einem der vorhergehenden Ansprüche,
dadurch **gekennzeichnet**,
daß für jeden Regelkreis eine Stromanstiegsbegrenzung (SB) mit jeweiligem Freilaufzweig (FZ) im Leistungszweig der Leistungsschalter (I,I',II,II') angeordnet wird, und daß der Strom durch zwei Stromsensoren (SS) in den jeweiligen Zweigen der Regelkreise gemessen wird, welche Stromsensoren unabhängig voneinander einstellbar sind, wobei die Regelkreise (ST1,ST2) von einer Mikroprozessorsteuerung (18) und einer analogen OP-Verstärkeranordnung (19) angesteuert werden, durch welche eine Leistungstreiberansteuerung (20) für die Leistungsschalter (I,I',II,II') gesteuert wird, und die Mikroprozessorsteuerung (18) und die analoge OP-Verstärkeranordnung (19) über je eine Schnittstelle mit einem Prozessrechner (21) verbunden sind.

**8.** Verfahren nach Anspruch 1 oder einem der Ansprüche 3 bis 7,
dadurch **gekennzeichnet**,
daß als Leistungsschalter (I,I',II,II') bipolare Transistoren IBGTs oder andere schnell schaltende elektronische Leistungshalbleiter verwendet werden.


**Claims**

**1.** Process for controlling the power supply of an installation used in plasma- and surface-treatment-technique, in which a power supply device for the bipolar power supply of the installation includes an adjustable DC mains adaptor, of which the positive and negative output terminals are connected to the input of a bridge circuit (I, I', II, II') of electronic power switches, which power switches are connected to a control signal processing device (12, 13) and, on the output side, to a current recording circuit (9, 10) for controlling the power switches and to the load of the installation, wherein, for the power switches (I, I') for generating the positive output voltage $U_\oplus$ and the power switches (II, II') for generating the negative output voltage $U_\ominus$ of the output signal $U_a$ of the bridge circuit, separate control signal processing devices (12, 13) and current recording circuits (9, 10) are provided for the individual control of the positive and negative output signals $U_a$, which are combined in separate control circuits, which are controlled independently of each other by a control device (18).

**2.** Process according to Claim 1,
characterised in that
the electronic power switches are formed by MOSFETs.

**3.** Process according to Claim 1 or 2,
characterised in that
the output of the bridge circuit (I, I', II, II') is connected to a shunt (8), of which the tapping is connected to the current recording circuit.

**4.** Process according to Claim 3,
characterised in that
the current recordal and evaluation units (9, 10) are connected to a monitoring unit (11), which monitors the maximum current, the average current, the temperature and an auxiliary voltage, which monitoring unit further is provided with a time lock, a reset and a display intensifier.

**5.** Process according to Claim 4,
characterised in that
the monitoring unit (11) is connected to a microprocessor (14), which controls the control signal processing devices (12, 13) via an interface (15).

**6.** Process according to one of the preceding claims,
characterised in that
the control signal processing devices (12, 13) are provided with a Schmitt trigger, a frequency limiter, a repeater driver and a lock for controlling the power switches (I, I', II, II').

**7.** Process according to one of the preceding claims,
characterised in that
for each control circuit a current increase limiter (SB) each with a neutral branch (FZ) is arranged in the power branch of the power switches, and that the current is measured by two current sensors (SS) in the respective branches of the control circuits, which current sensors are adjustable independently of each other, wherein the control circuits (ST1, ST2) are controlled by a microprocessor control (18) and an analogue OP-amplifier system (19) by which a power driver control (20) for the power switches (I, I', II, II') is controlled, and the microprocessor control (18) and the analogue OP-amplifier system are each connected via an interface to a process control computer (21).

**8.** Process according to Claim 1 or one of Claims 3 to 7,
characterised in that
bipolar transistors IBGTs or other fast-switching electronic power semiconductors are used as power switches (I, I', II, II').

**Revendications**

**1.** Procédé pour asservir l'alimentation d'une installation relevant de la technique des plasmas ou du traitement des surfaces, dans lequel un appareil d'alimentation en courant destiné à l'alimentation bipolaire de l'installation en courant comprend un bloc de réseau en courant continu qui peut être régulé et dont les bornes de sortie positive et négative sont reliées à l'entrée d'un circuit en pont (I, I', II, II') formé par des commutateurs électroniques de puissance, ces commutateurs de puissance étant reliés à un dispositif de préparation des signaux d'asservissement (12, 13) et, du côté de la sortie, à la charge de l'installation et à un circuit de détection du courant (9, 10) destiné à l'asservissement des commutateurs de puissance, cependant qu'il est prévu, pour les commutateurs de puissance (I, I') qui sont destinés à engendrer la tension de sortie positive $U\oplus$ du signal de sortie $U_a$ du circuit en pont et pour les commutateurs de puissance (II, II') qui sont destinés à engendrer sa tension de sortie négative $U_\ominus$ , des dispositifs de préparation des signaux d'asservissement (12, 13) et des circuits de détection du courant (8, 10) qui sont séparés en vue de la régulation individuelle des signaux de sortie positifs et négatifs $U_a$, ceux-ci étant réunis dans des circuits de régulation séparés qui sont asservis indépendamment les uns des autres par un dispositif d'asservissement (18).

**2.** Procédé selon la revendication 1, caractérisé par le fait que les commutateurs électroniques de puissance sont constitués par des transistors à effet de champ à grille isolée par un oxyde métallique (MOSFET).

**3.** Procédé selon la revendication 1 ou 2, caractérisé par le fait que la sortie du circuit en pont (I, I', II, II') est reliée à un shunt (8) dont la prise est reliée aux circuits de détection du courant.

**4.** Procédé selon la revendication 3, caractérisé par le fait que les unités (9, 10) de détection et d'exploitation du courant sont reliées à une unité de surveillance (11) qui surveille le courant maximal, le courant moyen, la température et une tension auxiliaire, cette unité de surveillance (11) étant en outre pourvue d'un délai d'attente, d'une remise à zéro et d'un amplificateur d'affichage.

**5.** Procédé selon la revendication 4, caractérisé par le fait que l'unité de surveillance (11) est reliée à un microprocesseur (14) qui commande les dispositifs de préparation des signaux d'asservissement (12, 13) par l'intermédiaire d'une interface (15).

**6.** Procédé selon l'une des revendications précédentes, caractérisé par le fait que les dispositifs de préparation des signaux d'asservissement (12, 13) sont pourvus d'une bascule de Schmitt, d'une limitation de la fréquence, d'un circuit de transfert et d'un verrouillage en vue de l'asservissement des commutateurs de puissance (I, I', II, II').

**7.** Procédé selon l'une des revendications précédentes, caractérisé par le fait que, pour chaque circuit de régulation, une limitation de l'augmentation du courant (SB) pourvue d'une branche de roue libre respective (FZ) est disposée dans la branche de puissance des commutateurs de puissance (I, I', II, II'), et par le fait que le courant qui passe à travers deux capteurs de courant (SS) est mesuré dans les branches respectives des circuits de régulation, ces capteurs de courant pouvant être réglés indépendamment l'un de l'autre, cependant que les circuits de régulation (ST1, ST2) sont excités par une commande par microprocesseur (18) et par un dispositif amplificateur analogique opérationnel (19) par lequel est commandée une excitation du circuit d'attaque de puissance (20) destinée aux commutateurs de puissance (I, I', II, II'), et que la commande par microprocesseur (18) et le dispositif amplificateur analogique opérationnel (19) sont reliés chacun à un calculateur de processus (21) par l'intermédiaire d'une interface.

**8.** Procédé selon la revendication 1 ou l'une des revendications 3 à 7, caractérisé par le fait que l'on utilise comme commutateurs de puissance (I, I', II, II') des transistors bipolaires à grille isolée ou d'autres serti-conducteurs de puissance électroniques à commutation rapide.

# Fig.1

# Fig.2

# Fig.3

$t_1 \geq 10\,\mu s$
$t_2 \geq 5\,\mu s$
$t_3 \geq 10\,\mu s$
$t_4 \geq 5\,\mu s$

# Fig.4

**Fig.5**

Schnittstelle — 15
Option: Potentialtrennung — int./ext.

externe Schnittstelle

Steuersignal-Aufbereitung 1 — 12
Schmittrigger
Frequenzbegrenzung
Überträger-Treiber
Verriegelung

Steuersignal-Aufbereitung 2 — 13
Schmittrigger
Frequenzbegrenzung
Überträger-Treiber
Verriegelung

Mikro-Prozessor — 14
Signalgenerator
Schnittstelle
Fehlersignale
Festprogramme — int./ext.
Kodierschalter

Überwachung — 11
Maximal-Strom
Mittlerer-Strom
Temperatur
Hilfsspannung
Zeitsperre
Reset/Anzeigen-Verst.

Modul-Treiber 1 — 17 — I
Modul-Treiber 2 — 17 — II
Modul-Treiber 3 — 17 — II'
Modul-Treiber 4 — 17 — I'

DL
L

shunt — 8
"Last" Plasma

Stromerfassung/auswertung 1 — 9
I max-Komparator
I max-analog
I mit-analog — bipolar

Stromerfassung/auswertung 2 — 10
I max-Komparator
I max-analog
I mit-analog — bipolar

Stromversorgung — 16
Netz
ac
dc
+/- 15V

EP 0 534 068 B1

Fig.6

Schnittstelle 15

externe Schnittstelle

Option:
Potentialtrennung                int./ext.

Mikro-Prozessor 14

Signalgenerator
Schnittstelle
Fehlersignale
Festprogramme        int./ext.
- - - - - - - - - -
Kodierschalter

16

Netz

ac                dc
              +/- 15V

Stromversorgung

Steuersignal-Aufbereitung 12

Schmittrigger
Frequenzbegrenzung
Überträger-Treiber

Überwachung 11

Maximal-Strom
Mittlerer-Strom
Temperatur
Hilfsspannung
Zeitsperre
Reset
Anzeige – Verst.

Stromerfassung/auswertung

Imax-Komparator
Imax-analog         bipolar
Imit-analog

9

Modul-Treiber 1

1·   ·5
2
3    ·4

17

Modul-Treiber 2

1·   ·5
2
3    ·4

17

Modul-Treiber n

17

1·   ·5
2
3    ·4

shunt

8

EP 0 534 068 B1

12

Fig.7

Fig.8

EP 0 534 068 B1

21 — Prozessrechner

$u_a(t)$, $i_a(t)$   $u_\oplus(t)$, $i_\ominus(t)$   [μs – sec.]   $u(t)$, $i(t)$

Meßzyklus $\tau$

Vakuumsystem

mathematische Operationen

$$P_\oplus = \int_0^\tau U_\oplus(t) \cdot i_\oplus(t)\, dt$$
$$P_\ominus = \int_0^\tau U_\ominus(t) \cdot i_\ominus(t)\, dt$$

$\Delta P = P_\oplus - P_\ominus = \text{const.}$

$\Delta P$ beliebig zwischen $P_\oplus$ und $P_\ominus$ einstell- und regelbar.

analog: $\Delta U = U_\oplus - U_\ominus = \text{const.}$
$\Delta J = J_\oplus - J_\ominus = \text{const.}$

Prozessvektor $\vec{P} \begin{pmatrix} P_1 \\ P_2 \\ \vdots \\ P_P \end{pmatrix}$

19 — Schnelle Regelung mit beliebig konfigurierbaren mathematischen Operationen

$(\Delta P, P_\oplus, P_\ominus)$ manuell
$(\Delta U, U_\oplus, U_\ominus)$ einstellbar
$(\Delta J, J_\oplus, J_\ominus)$ Sollwerte

Regelvektor $\vec{R} \begin{pmatrix} R_1 \\ R_2 \\ \vdots \\ R_R \end{pmatrix}$

elektrisch leitende Grenzfläche A

Sensorik Temperatur $\vartheta$ Spannungspotential $U_{pot.}$ etc.

$\vec{E}$-Feld

SU

18 — μ-Prozessor-Steuerung
Steuerung I, Steuerung II
Spannungs- und Stromerfassung $u(t)$, $i(t)$

Plasmaintensität = Funktion$(x,y,z,t, U_\oplus, U_\ominus, J_\oplus, J_\ominus, \vartheta, U_{pot.}....)$

Spannung Strom

Pulszeiten, $u_\oplus(t)$, $u_\ominus(t)$
Arcmeldung, $i_\oplus(t)$, $i_\ominus(t)$

Netz

$U_E(t)$

$u_a(t)$ $i_a(t)$ t

$u_a(t) = u_\oplus(t) + u_\ominus(t)$

elektrisch leitende Grenzfläche B

z, y, x